# FASCICULE DE BREVET EUROPEEN

(11) **EP 1 825 278 B1**
(45) Date de publication et mention de la délivrance du brevet: **23.01.2008**
(21) Numéro de dépôt: 05813480.0
(22) Date de dépôt: 05.12.2005
(51) Int. Cl.: G01R 11/04

(54) **DISPOSITIF DE CONNEXION ELECTRIQUE POUR COMPTEUR ELECTRIQUE POLYPHASE**
ELEKTRISCHE VERBINDUNGSEINRICHTUNG FÜR EINEN POLYPHASEN-STROMZÄHLER
ELECTRIC CONNECTION DEVICE FOR A POLYPHASE ELECTRIC METER

(30) Priorité: 17.12.2004 FR 0453060
(43) Date de publication de la demande: 29.08.2007
(73) Titulaire: Actaris SAS, 92100 Boulogne Billancourt (FR)
(72) Inventeur: HERNOUX, Luc, F-86170 Cissé (FR)
(74) Mandataire: Hervouet, Sylvie
(86) Numéro de dépôt international: PCT/EP2005/056487
(87) Numéro de publication internationale: WO 2006/063954

(56) Documents cités:
- EP-A- 0 825 629
- WO-A-99/08119
- DE-A1- 2 235 920
- DE-A1- 19 526 287
- DE-U- 7 420 267
- PATENT ABSTRACTS OF JAPAN vol. 1996, no. 01, 31 janvier 1996 (1996-01-31) & JP 07 248343 A (SUKEAKI HAIJIMA; others: 02), 26 septembre 1995 (1995-09-26)

## Description

La présente invention concerne le domaine des compteurs électriques, et plus particulièrement les opérations de calibrage de ces compteurs électriques.

Un compteur électrique comporte, de manière classique, au moins un circuit de courant et un circuit de tension. Dans le cas d'un compteur électrique monophasé, ce dernier comporte une unique paire ou ensemble constitué d'un circuit de courant et d'un circuit de tension, alors que dans le cas d'un compteur polyphasé, le compteur dispose d'autant de paires ou sous-ensembles de circuit courant/circuit tension qu'il y a de phases.

Lorsque le compteur électrique est dans son mode normal de fonctionnement, c'est-à-dire connecté au réseau électrique général, les circuits de courant et de tension d'une même paire ou sous-ensemble doivent être connectés électriquement.

En revanche, lors du test avant installation ou suite à une réparation d'un compteur électrique, il est nécessaire de calibrer les circuits de tension et de courant d'une même paire, et ce, de façon indépendante. En conséquence, en mode de calibrage, les circuits de tension et de courant d'une même paire ou sous-ensemble doivent être isolés électriquement.

La fonctionnalité qui permet de connecter ou de déconnecter électriquement les circuits de courant et de tension d'une même paire est connue sous la terminologie anglo-saxonne « I/P link », qui signifie qu'un lien électrique peut ou non exister entre le circuit de courant (1) et le circuit de tension ou de phase (P).

On s'intéresse plus particulièrement dans la suite de l'exposé aux moyens spécifiques permettant de réaliser cette fonctionnalité « I/P link ». Ces moyens devant fonctionner comme un interrupteur permettant les opérations de connexion et de déconnexion, on les désignera en conséquence dans la suite par la terminologie plus générale de moyens de connexion/déconnexion électrique.

Une première solution connue pour réaliser une connexion/déconnexion électrique consiste à équiper le compteur d'une barrette métallique, par exemple en laiton, maintenue par deux vis entre la borne de courant et la borne de tension des circuits de courant et de tension d'une même paire, et d'une pièce métallique formant un pont électrique dont une extrémité est vissée sur la borne de courant, et dont l'autre extrémité peut être vissée soit sur la barrette métallique, soit sur la borne de tension, selon que l'on souhaite déconnecter ou connecter les circuits. La pièce métallique comporte une ouverture oblongue de façon à permettre un déplacement de cette pièce par translation entre les deux positions précédentes. On constate que cette réalisation est tout d'abord coûteuse compte tenu du nombre d'éléments nécessaires. En outre, il est nécessaire d'avoir un outil spécifique, à savoir un tournevis spécifique, pour pouvoir manoeuvrer cette connexion électrique selon que l'on souhaite connecter ou déconnecter les circuits. Par ailleurs, la manipulation par l'utilisateur n'est pas simple car, pour chaque connexion ou déconnexion à effectuer, il est nécessaire de dévisser trois vis, de faire subir un mouvement de translation à la pièce, puis de revisser les trois vis. Si le compteur est de plus polyphasé, par exemple triphasé, l'opération devra être réitérée trois fois. Aussi, si l'utilisateur ne referme par correctement les 3 ponts, le compteur reste complètement ou partiellement en mode calibration et la fonction principale de comptage du mode normal du compteur n'est plus assurée.

Une autre solution connue a été apportée de façon à simplifier la connexion précédente, tant en terme de nombre de pièces nécessaires, qu'en terme de manipulation. Dans cette solution, mise en oeuvre par exemple dans le compteur électrique de référence ACE 3000 type 260 commercialisé par le Demandeur, la connexion électrique est réalisée par l'intermédiaire d'une lame élastique dont les extrémités sont, en position de repos de la lame, en contact avec d'une part, la borne de courant, et d'autre part, la borne de tension, de sorte que les circuits de courant et de tension sont électriquement reliés. Pour le mode de calibrage, l'utilisateur peut, à l'aide d'un outil spécifique, typiquement un plongeur, qu'il introduit au travers d'une ouverture prévue dans le boîtier du compteur, agir sur la lame de manière à éloigner, par déformation élastique de la lame, l'une des extrémités de cette lame de l'une des bornes, et procéder ainsi à la déconnexion des circuits.

Bien que cette solution apporte des simplifications, l'utilisateur doit toujours disposer d'un outil spécifique, et surtout, dans le cas d'un compteur polyphasé, les opérations doivent toujours être menées successivement pour chacun des sous-ensembles du compteur. Le document WO99/08119 A décrit un dispositif de déconnexion et un compteur selon les préambules des revendications 1 et 6 respectivement.

La présente invention a pour but de pallier aux limitations précédentes en proposant un outillage particulier permettant de réaliser simultanément et de manière simple les opérations de connexion/déconnexion de N paires ou sous-ensembles de circuits courant/tension d'un compteur électrique polyphasé.

Plus précisément, la présente invention a pour premier objet un dispositif de déconnexion électrique destiné à être utilisé conjointement avec un compteur électrique, ledit compteur électrique étant du type polyphasé comprenant un nombre N supérieur à un de sous-ensembles chacun mnstitué d'un circuit de courant et d'un circuit de tension, chaque sous-ensemble étant muni d'une lame élastique réalisant, en position de repos, une liaison électrique entre une borne du circuit de courant et une borne du circuit de tension, et le compteur étant en outre muni, au niveau d'une boîte à bornes, de N ouvertures permettant un accès depuis l'extérieur du compteur à chaque lame, le dispositif étant caractérisé en ce qu'il comporte un support portant un nombre N d'extensions s'étendant parallèlement les unes par rapport aux autres, présentant chacune une extrémité libre et disposées le long du support de façon à ce que les extensions puissent être introduites simultanément par une manipulation du support dans chacune des N ouvertures, chaque extrémité libre venant agir simultanément sur la lame élastique correspondante pour déconnecter chacune des liaisons électriques.

De cette façon, les opérations de l'utilisateur se voient considérablement simplifiées puisque l'utilisateur peut, en un seul geste, soit déconnecter simultanément tous les circuits de courant et de tension de tous les sous-ensembles lors de l'introduction du dispositif, soit reconnecter simultanément ces mêmes circuits lors du retrait du dispositif.

La présente invention a également pour objet un compteur électrique du type polyphasé comprenant un nombre N supérieur à un de sous-ensembles chacun constitué d'un circuit de courant et d'un circuit de tension, chaque sous-ensemble étant muni d'une lame élastique réalisant, en position de repos, une liaison électrique entre une borne du circuit de courant et une borne du circuit de tension, le compteur étant en outre muni, au niveau d'une boîte à bornes, de N ouvertures permettant un accès depuis l'extérieur du compteur à chaque lame, caractérisé en ce qu'il est équipé en outre d'un dispositif de déconnexion amovible qui comporte un support portant un nombre N d'extensions s'étendant parallèlement les unes par rapport aux autres, présentant chacune une extrémité libre et disposées le long du support de façon à ce que les extensions puissent être introduites simultanément par une manipulation du support dans chacune des N ouvertures, chaque extrémité libre venant agir simultanément sur la lame élastique correspondante pour déconnecter chacune des liaisons électriques.

Ainsi, en prévoyant d'équiper directement un compteur du dispositif de déconnexion conforme à la présente invention, on évite que l'utilisateur ne puisse pas mener à bien les opérations de déconnexion.

Avantageusement, on prévoit sur le compteur des moyens de maintien du dispositif de connexion dans une position de non utilisation.

Avantageusement, on prévoit en outre des moyens de maintien du dispositif de connexion dans une position d'utilisation.

La présente invention sera mieux comprise au vu de la description suivante faite en référence aux figures annexées, dans lesquelles :
- les figures 1 A et 1 B illustrent deux perspectives d'un dispositif selon un premier mode de réalisation possible, destiné à un compteur électrique triphasé ;
- la figure 2 illustre en perspective partiellement coupée la coopération du dispositif de la figure 1 avec l'une des trois paires d'un compteur électrique triphasé ;
- la figure 3 est un agrandissement partiel de la figure 2 ;
- la figure 4 illustre un exemple de réalisation de lame élastique ;
- les figures 5A et 5B illustrent deux perspectives d'un dispositif selon un second mode de réalisation possible, destiné également à un compteur électrique triphasé ;
- la figure 5C est une vue en élévation du dispositif des figures 5A et 5C ;
- les figures 6A à 6E illustrent les opérations successives à réaliser pour utiliser le dispositif selon l'invention.

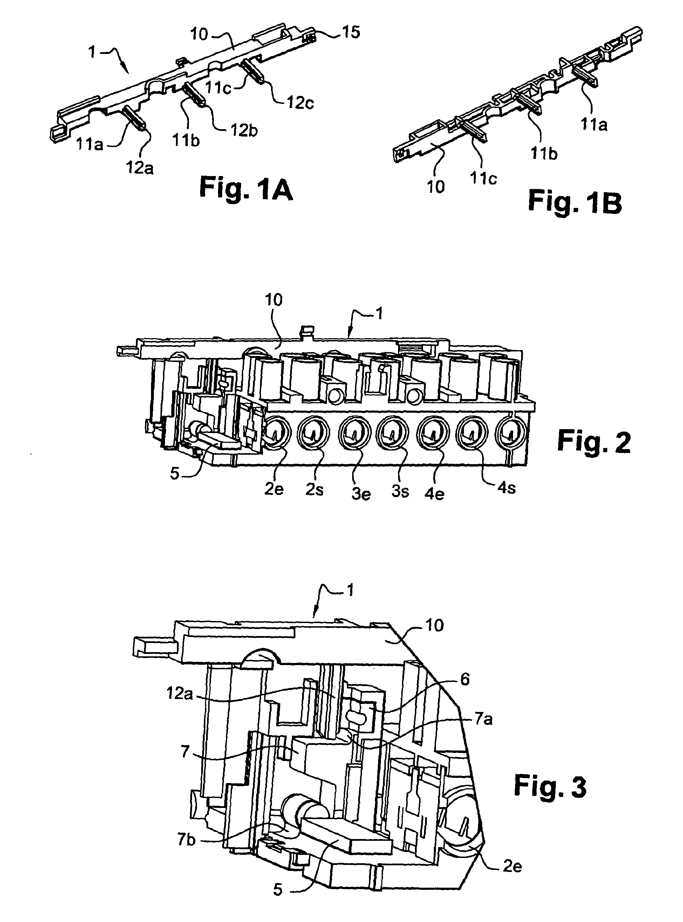

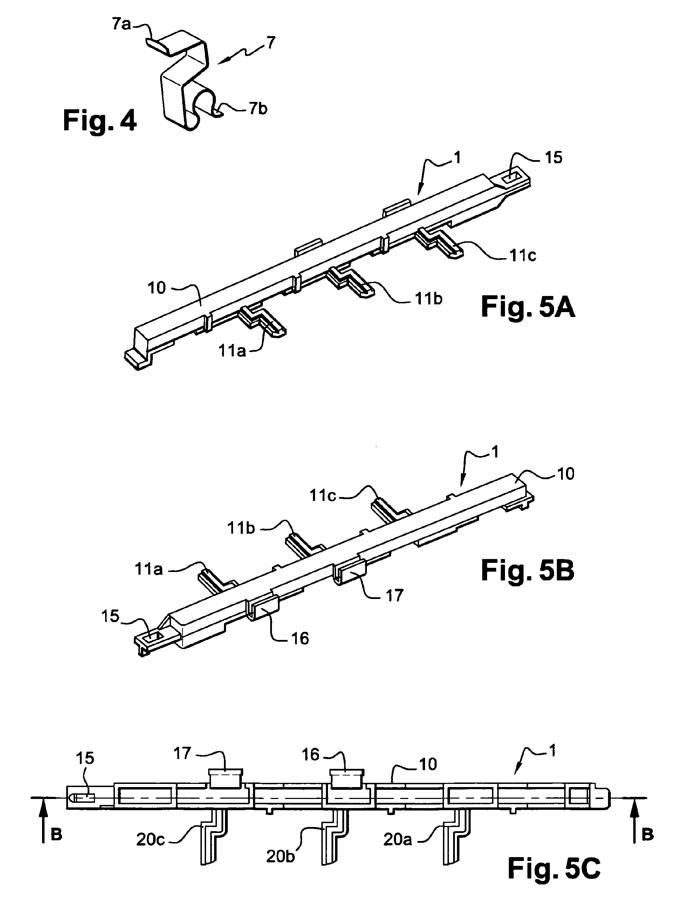

En référence tout d'abord aux figures 1 à 4 annexées, le dispositif de déconnexion électrique 1 conforme à l'invention destiné à être utilisé conjointement avec un compteur électrique triphasé comprenant trois sous-ensembles chacun constitué d'un circuit de courant et d'un circuit de tension. Bien entendu, l'invention est généralisable à tout compteur polyphasé, quel que soit le nombre N de sous-ensembles effectivement présents dans le compteur. Comme visible sur la figure 2 et sur la figure 3 qui représente un agrandissement partiel de la figure 2, chaque sous-ensemble est destiné à être relié par une borne d'entrée 2e, 3e et 4e et une borne de sortie 2s, 3s et 4s au réseau électrique général non représenté. Ces bornes d'entrée et de sortie sont localisées dans une partie du compteur appelée boîte à bornes, généralement placée dans la partie inférieure du compteur électrique. Chaque sous-ensemble comporte classiquement un circuit de courant 5 et un circuit de tension dont on a référencé seulement une borne de connexion 6. Comme déjà décrit précédemment, ces deux circuits d'un même sous-ensemble doivent, lors du mode de fonctionnement normal du compteur, être connectés électriquement. La liaison électrique entre la borne 5 du circuit de courant et la borne 6 du circuit de tension est réalisée avantageusement par une lame élastique 7 dont la forme est bien visible sur la figure 4. En position de repos, les deux extrémités 7a et 7b de cette lame sont en contact respectivement avec les bornes 6 et 5. L'extrémité 7a est cependant une extrémité libre sur laquelle il est possible d'agir pour déformer élastiquement la lame et éloigner l'extrémité 7a de la borne 6. A noter que la borne 5 du circuit de courant peut être constituée par toute partie métallique du circuit de courant primaire, par exemple l'enroulement du primaire du capteur de courant.

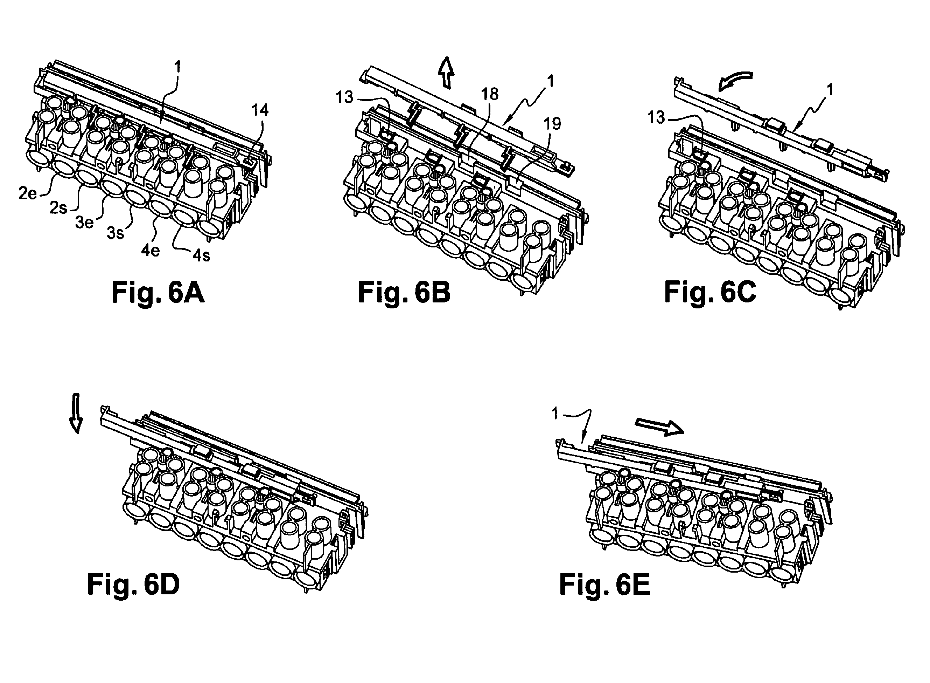

Conformément à l'invention, le dispositif de déconnexion comporte un support 10 portant un nombre N d'extensions, ici trois extensions référencées 11 a, 11 b et 11 c. Les extensions s'étendent parallèlement les unes par rapport aux autres, et présentent chacune une extrémité fibre 12a, 12b, 12c. Le compteur est quant à lui muni, au niveau de la boîte à bornes, de trois ouvertures (référencées 13 sur les figures 6B et 6C) permettant un accès depuis l'extérieur du compteur à chacune des lames de chacun des sous-ensembles. Les extensions 11 a, 11 b et 11 c du dispositif 1 selon l'invention sont disposées le long du support 10 de façon à ce que les extensions puissent être introduites simultanément par une manipulation du support dans chacune des trois ouvertures 13. Chaque extrémité libre 12a, 12b, 12c vient alors agir simultanément sur la lame élastique 7 correspondante pour déconnecter chacune des liaisons électriques. L'action de l'extrémité 12a de l'extension 11 a sur l'une des lames 7 est visible sur la figure 3.

Dans le mode de réalisation représenté, le support 10 se présente sous la forme d'une barrette longitudinale et les extensions 11a, 11 b, 11 c s'étendent perpendiculairement par rapport à l'axe longitudinal de la barrette. La barrette longitudinale 10 constitue pour l'utilisateur un élément de préhension pour la mise en place ou le retrait du dispositif 1 selon que l'on souhaite déconnecter les circuits ou au contraire les connecter.

De préférence, le dispositif est réalisé en une pièce unique en matériau isolant, les extensions 11 a, 11 b, 11 c étant venues de moulage avec le support 10.

Les figures 5A, 5B et 5C illustrent un second mode de réalisation possible d'un dispositif de déconnexion conforme à l'invention. Ce dispositif comporte, comme dans le premier mode décrit précédemment, une barrette longitudinale 10 formant support pour trois extensions 11a, 11 b, 11 c destinées à venir agir simultanément sur une lame comme explicité précédemment. La différence avec le dispositif du premier mode de réalisation réside essentiellement dans la forme des extensions destinée à réaliser des fonctions supplémentaires qui vont être explicitées ci-après en référence aux figures 6A à 6D.

La figure 6A illustre le point de départ d'une opération de déconnexion lors de laquelle un utilisateur va être amené à utiliser le dispositif de déconnexion pour déconnecter simultanément les différents circuits. Dans cette configuration de départ, le dispositif de déconnexion 1 est avantageusement maintenu dans une position de repos ou de non utilisation, au niveau du compteur, par exemple au niveau de la boîte à borne. Pour ce faire, le compteur dispose de moyens de maintien, réalisés dans l'exemple sous la forme d'un ergot 14 coopérant, par exemple par clipsage, avec une ouverture 15 (voir figures 1, et 5A à 5C) du dispositif de déconnexion pour maintenir le dispositif dans cette position de non utilisation. Pour renforcer le maintien du dispositif dans cette position et éviter notamment toute translation longitudinale du support, les moyens de maintien peuvent en outre comporter, au niveau du dispositif, des pattes de maintien 16 et 17 (voir figures 5B et 5C) venant s'insérer dans des logements 18, 19 (voir figure 6B) correspondants sur le compteur, configuration communément appelée I/P link interne car demandant l'ouverture de l'enceinte métrologique.

Lorsque l'utilisateur veut utiliser le dispositif, il retire ce dernier comme indiqué sur la figure 6B. On note au passage que le retrait du dispositif 1 laisse apparaître les ouvertures d'accès 13 aux lames. En conséquence, la position de non utilisation du dispositif telle que montrée sur la figure 6A permet en outre avantageusement de protéger l'accès aux ouvertures en plaçant le support de telle manière qu'il recouvre ces ouvertures. Dans cette position de non utilisation, les extensions s'étendant quant à elles de préférence dans un plan sensiblement parallèle au plan des ouvertures, de manière à optimiser l'encombrement.

L'utilisateur doit ensuite faire pivoter de 90° le dispositif 1 de déconnexion, comme illustré sur la figure 6C, de façon à amener les extensions dans un plan sensiblement perpendiculaire au plan des ouvertures 13, et autoriser l'introduction de chacune des extensions dans les ouvertures associées. Cette introduction s'effectue par simple manoeuvre du dispositif suivant la direction de la flèche telle que représentée sur la figure 6D. L'utilisateur doit enfin imprimer au support une dernière translation parallèle à l'axe longitudinal du support 1, comme l'indique la flèche de la figure 6E, pour amener les extrémités des extensions 11 a à 11 c à déconnecter les lames correspondantes.

Pour libérer les mains de l'utilisateur afin qu'il puisse effectuer d'autres opérations, notamment les opérations propres au calibrage, le dispositif doit être de préférence maintenu également dans sa position d'utilisation. Pour ce faire, on prévoit également des moyens de maintien du dispositif dans sa position d'utilisation. Dans l'exemple représenté, ces moyens sont formés par un décrochement ou épaulement 20a, 20b, 20c situé sur chaque extension (voir figure 5C), venant coopérer avec une rainure non représentée au niveau du compteur.

En comparant la position de non utilisation du dispositif telle que représentée à la figure 6A par rapport à la position d'utilisation représentée à la figure 6E, on note que dans la position d'utilisation, une partie extrémale du support 1 (à gauche sur la figure 6E) est en saillie par rapport à la boîte à bornes. Cette précaution permet avantageusement d'éviter que l'utilisateur n'oublie d'enlever le dispositif de déconnexion de sa position d'utilisation. En effet, la partie faisant saillie empêche à l'utilisateur de remettre le couvercle ou couvre borne (non représenté) du boîtier par dessus la boîte à bornes.

## Revendications

1. Dispositif (1) de déconnexion électrique destiné à être utilisé conjointement avec un compteur électrique, ledit compteur électrique étant du type polyphasé comprenant un nombre N supérieur à un de sous-ensembles chacun constitué d'un circuit de courant et d'un circuit de tension, chaque sous-ensemble étant muni d'une lame élastique (7) réalisant, en position de repos, une liaison électrique entre une borne (5) du circuit de courant et une borne (6) du circuit de tension, et le compteur étant en outre muni, au niveau d'une boîte à bornes, de N ouvertures (13) permettant un accès depuis l'extérieur du compteur à chaque lame, le dispositif étant **caractérisé en ce qu'**il comporte un support (10) portant un nombre N d'extensions (11 a-11 c) s'étendant parallèlement les unes par rapport aux autres, présentant chacune une extrémité libre (12a-12c) et disposées le long du support (10) de façon à ce que les extensions puissent être introduites simultanément par une manipulation du support dans chacune des N ouvertures (13), chaque extrémité libre (12a-12c) venant agir simultanément sur la lame élastique correspondante pour déconnecter chacune des liaisons électriques.

2. Dispositif selon la revendication 1, **caractérisé en ce que** ledit support (10) comporte une barrette longitudinale et **en ce que** lesdites extensions s'étendent perpendiculairement par rapport à l'axe longitudinal de la barrette.

3. Dispositif selon l'une quelconque des revendications précédentes, **caractérisé en ce que** le dispositif est réalisé en une pièce unique en matériau isolant, les extensions (11 a-11 c) étant venues de moulage avec le support (10).

4. Dispositif selon l'une quelconque des revendications précédentes, **caractérisé en ce que** le support (1) présente une ouverture (15) susceptible de coopérer avec un ergot (14) au niveau du compteur pour maintenir le dispositif dans une position de non utilisation.

5. Dispositif selon l'une quelconque des revendications précédentes, **caractérisé en ce que** chaque extension présente un décrochement (20a-20c) destiné à coopérer avec une rainure au niveau du compteur pour maintenir le dispositif dans une position d'utilisation.

6. Compteur électrique du type polyphasé comprenant un nombre N supérieur à un de sous-ensembles chacun constitué d'un circuit de courant et d'un circuit de tension, chaque sous-ensemble étant muni d'une lame élastique (7) réalisant, en position de repos, une liaison électrique entre une borne (5) du circuit de courant et une borne (6) du circuit de tension, le compteur étant en outre muni, au niveau d'une boîte à bornes, de N ouvertures (13) permettant un accès depuis l'extérieur du compteur à chaque lame, **caractérisé en ce qu'**il est équipé en outre d'un dispositif (1) de déconnexion amovible qui comporte un support (10) portant un nombre N d'extensions (11 a-11 c) s'étendant parallèlement les unes par rapport aux autres, présentant chacune une extrémité libre (12a-12b) et disposées le long du support de façon à ce que les extensions puissent être introduites simultanément par une manipulation du support dans chacune des N ouvertures (13), chaque extrémité libre (11a-11c) venant agir simultanément sur la lame élastique correspondante pour déconnecter chacune des liaisons électriques.

7. Compteur électrique selon la revendication 6, **caractérisé en ce qu'**il comporte des moyens (14-18) de maintien du dispositif (1) de connexion dans une position de non utilisation.

8. Compteur électrique selon la revendication 7, **caractérisé en ce que** lesdits moyens de maintien (14-18) sont disposés de façon à ce que, lorsque le dispositif est dans sa position de non utilisation, le support (10) recouvre chacune des N ouvertures (13).

9. Compteur électrique selon l'une quelconque des revendications 7 ou 8, **caractérisé en ce que**, lorsque le dispositif est dans sa position de non utilisation, les extensions s'étendent dans un plan sensiblement parallèle au plan des ouvertures. (13).

10. Compteur électrique selon l'une quelconque des revendications 6 à 9, **caractérisé en ce qu'**il comporte en outre des moyens (20a-20c) de maintien du dispositif (1) de connexion dans une position d'utilisation.

11. Compteur électrique selon la revendication 10, **caractérisé en ce que** lesdits moyens de maintien dans la position d'utilisation comportent des décrochements (20a-20c) au niveau de chaque extension (11 a-11 c) du dispositif (1), coopérant avec une rainure au niveau du compteur.

## Claims

1. An electrical disconnector device (1) for use together with an electricity meter, said electricity meter being of the polyphase type having a number, N, of subassemblies each constituted by a current circuit and by a voltage circuit, where the number N is greater than one, each subassembly being provided with a spring blade (7) acting in a rest position to make an electrical connection between a terminal (5) of the current circuit and a terminal (6) of the voltage circuit, and the meter being also provided, in a terminal box, with N openings (13) giving access from outside the meter to each of the blades, the device being **characterized in that** it comprises a support (10) carrying a number N of extensions (11a-11c) extending parallel to one another, each presenting a free end (12a-12c), and disposed along the support (10) in such a manner that the extensions can be inserted simultaneously into each of the N openings (13) by a single operation of manipulating the support, each free end (12a-12c) acting simultaneously on the corresponding spring blade to disconnect each of the electrical connections.

2. A device according to claim 1, **characterized in that** said support (10) comprises a longitudinal strip and **in that** said extensions extend perpendicularly relative to the longitudinal axis of the strip.

3. A device according to either preceding claim, **characterized in that** the device is made as a single piece of insulating material, the extensions (11a-11c) being integrally molded with the support (10).

4. A device according to any preceding claim, **characterized in that** the support (1) presents an opening (15) suitable for co-operating with a stud (14) on the meter for holding the device in a non-use position.

5. A device according to any preceding claim, **characterized in that** each extension presents a step (20a-20c) for co-operating with a groove in the meter in order to hold the device in an in-use position.

6. A polyphase type electricity meter comprising a number N of subassemblies, where N is greater than one, each subassembly being constituted by a current circuit and by a voltage circuit, each subassembly being provided with a spring blade (7) acting in a rest position to make an electrical connection between a terminal (5) of the current circuit and a terminal (6) of the voltage circuit, and the meter being also provided, in a terminal box, with N openings (13) giving access from outside the meter to each of the blades, the meter being **characterized in that** it is also fitted with a removable disconnector device (1) comprising a support (10) carrying a number N of extensions (11a-11c) extending parallel to one another, each presenting a free end (12a-12b), and disposed along the support in such a manner that the extensions can be inserted simultaneously into each of the N openings (13) by a single operation of manipulating the support, each free end (11a-11c) acting simultaneously on the corresponding spring blade to disconnect each of the electrical connections.

7. An electricity meter according to claim 6, **characterized in that** it includes holder means (14-18) for holding the disconnector device (1) in a non-use position.

8. An electricity meter according to claim 7, **characterized in that** said holder means (14-18) are disposed in such a manner that when the device is in its non-use position, the support (10) covers each of the N openings (13).

9. An electricity meter according to claim 7 or claim 8, **characterized in that**, when the device is in its non-use position, the extensions extend in a plane that is substantially parallel to the plane of the openings (13).

10. An electricity meter according to any one of claims 6 to 9, **characterized in that** it further comprises holder means (20a-20c) for holding the disconnector device (1) in an in-use position.

11. An electricity meter according to claim 10, **characterized in that** said holder means for holding the device in the in-use position comprise steps (20a-20c) in each extension (11a-11c) of the device (1), co-operating with a groove in the meter.

## Patentansprüche

1. Vorrichtung (1) zum Trennen der elektrischen Verbindung, die dazu bestimmt ist, zusammen mit einem Stromzähler verwendet zu werden, wobei der Stromzähler vom Mehrphasentyp ist, der eine Anzahl N größer als eins von Untereinheiten aufweist, die je aus einem Stromkreis und einem Spannungskreis bestehen, wobei jede Untereinheit mit einer elastischen Lamelle (7) versehen ist, die in Ruhestellung eine elektrische Verbindung zwischen einer Klemme (5) des Stromkreises und einer Klemme (6) des Spannungskreises herstellt, und der Zähler außerdem in Höhe einer Klemmenleiste mit N Öffnungen (13) versehen ist, die einen Zugriff von außerhalb des Zählers auf jede Lamelle erlauben, wobei die Vorrichtung **dadurch gekennzeichnet ist, dass** sie einen Träger (10) aufweist, der eine Anzahl N von Verlängerungen (11a-11c) trägt, die sich parallel zueinander erstrecken, je ein freies Ende (12a-12c) aufweisen und entlang des Trägers (10) so angeordnet sind, dass die Verlängerungen gleichzeitig durch eine Handhabung des Trägers in jede der N Öffnungen (13) eingeführt werden können, wobei jedes freie Ende (12a-12c) gleichzeitig auf die entsprechende elastische Lamelle einwirkt, um jede der elektrischen Verbindungen zu trennen.

2. Vorrichtung nach Anspruch 1, **dadurch gekennzeichnet, dass** der Träger (10) eine Längsleiste aufweist und dass die Verlängerungen sich lotrecht zur Längsachse der Leiste erstrecken.

3. Vorrichtung nach einem der vorhergehenden Ansprüche, **dadurch gekennzeichnet, dass** sie aus einem Stück aus isolierendem Werkstoff hergestellt wird, wobei die Verlängerungen (11a-11c) mit dem Träger (10) geformt werden.

4. Vorrichtung nach einem der vorhergehenden Ansprüche, **dadurch gekennzeichnet, dass** der Träger (1) eine Öffnung (15) aufweist, die mit einem Zapfen (14) in Höhe des Zählers zusammenwirken kann, um die Vorrichtung in einer Stellung der Nicht-Benutzung zu halten.

5. Vorrichtung nach einem der vorhergehenden Ansprüche, **dadurch gekennzeichnet, dass** jede Verlängerung einen Absatz (20a-20c) aufweist, der dazu bestimmt ist, mit einer Rille in Höhe des Zählers zusammenzuwirken, um die Vorrichtung in einer Benutzungsstellung zu halten.

6. Stromzähler vom Mehrphasentyp, der eine Anzahl N größer als eins von Untereinheiten aufweist, die je aus einem Stromkreis und einem Spannungskreis bestehen, wobei jede Untereinheit mit einer elastischen Lamelle (7) versehen ist, die in Ruhestellung eine elektrische Verbindung zwischen einer Klemme (5) des Stromkreises und einer Klemme (6) des Spannungskreises herstellt, wobei der Zähler außerdem in Höhe einer Klemmenleiste mit N Öffnungen (13) versehen ist, die einen Zugriff von außerhalb des Zählers auf jede Lamelle erlauben, **dadurch gekennzeichnet, dass** er außerdem mit einer lösbaren Trennvorrichtung (1) versehen ist, die einen Träger (10) aufweist, der eine Anzahl N von Verlängerungen (11a-11c) trägt, die sich parallel zueinander erstrecken, je ein freies Ende (12a-12b) aufweisen und entlang des Trägers so angeordnet sind, dass die Verlängerungen gleichzeitig durch eine Handhabung des Trägers in jede der N Öffnungen (13) eingeführt werden können, wobei jedes freie Ende (11a-11c) gleichzeitig auf die entsprechende elastische Lamelle einwirkt, um jede der elektrischen Verbindungen zu trennen.

7. Stromzähler nach Anspruch 6, **dadurch gekennzeichnet, dass** er Einrichtungen (14-18) zum Halt der Verbindungsvorrichtung (1) in einer Stellung der Nicht-Benutzung aufweist.

8. Stromzähler nach Anspruch 7, **dadurch gekennzeichnet, dass** die Haltemittel (14-18) so angeordnet sind, dass, wenn die Vorrichtung in ihrer Stellung der Nicht-Benutzung ist, der Träger (10) jede der N Öffnungen (13) bedeckt.

9. Stromzähler nach einem der Ansprüche 7 oder 8, **dadurch gekennzeichnet, dass**, wenn die Vorrichtung in ihrer Stellung der Nicht-Benutzung ist, die Verlängerungen sich in einer Ebene im Wesentlichen parallel zur Ebene der Öffnungen (13) erstrecken.

10. Stromzähler nach einem der Ansprüche 6 bis 9, **dadurch gekennzeichnet, dass** er außerdem Einrichtungen (20a-20c) zum Halt der Verbindungsvorrichtung (1) in einer Benutzungsstellung aufweist.

11. Stromzähler nach Anspruch 10, **dadurch gekennzeichnet, dass** die Einrichtungen zum Halt in der Benutzungsstellung Absätze (20a-20c) in Höhe jeder Verlängerung (11a-11c) der Vorrichtung (1) aufweisen, die mit einer Rille in Höhe des Zählers zusammenwirken.
